# EUROPEAN PATENT APPLICATION

(11) **EP 4 478 270 A1**
(43) Date of publication of application: **18.12.2024**
(21) Application number: 24181761.8
(22) Date of filing: 12.06.2024
(51) Int. Cl.: G06Q 10/0635, G06Q 10/10, G06Q 50/04

(54) **METHOD OF MANUFACTURING ANALYSIS WITH ONTOLOGIES AND SEMANTIC ANALYSIS**

(30) Priority: 14.06.2023 US 202363508188 P; 22.04.2024 US 202418641819
(71) Applicant: The Boeing Company, Arlington, VA 22202 (US)
(72) Inventor: SHINOZAKI, JOHN MAKOTO, Arlington, 22202 (US)
(74) Representative: Bugnion S.p.A. - US1

(57) **Abstract**

Manufacturing analysis is provided. The method comprises identifying a feature of a product model defined by geometric, physical, and systems elements with semantic labels, names or title descriptions. Machine readable semantic links are created that connect the feature to elements in an enterprise knowledge library according to a machine readable ontological knowledge model. A producibility risk or opportunity for the product model is identified according to semantic relationships of the elements in the enterprise knowledge library linked to the feature. A user is alerted of the producibility risk or opportunity, and a note is added to a manufacturing design specification for the product model. The note provides a number of solutions for the producibility risk or opportunity, wherein the solutions are identified in the enterprise knowledge library according to the semantic relationships.

## Description

### CROSS-REFERENCE TO RELATED APPLICATION

This application claims the benefit of U.S. Provisional Patent Application Serial No. 63/508,188, filed June 14, 2023, and entitled "Method of Manufacturing Anaysis with Ontologies and Semantic Analysis".

### BACKGROUND INFORMATION

### Technical Field:

The present disclosure relates generally to manufacturing, and more specifically to computer-aided modeling systems for manufacturing.

### Background:

Manufacturing has a primary requirement set which comes from the product to be manufactured. Requirements may be derived from three-dimensional (3D) specifications used in computer-aided modeling. Computer-aided modeling or computer-aided design (CAD) creates virtual models of objects or systems, which allows engineers and designers to visualize and simulate structures or processes. Manufacturing can get requirements from other system domains such as facility requirements/constraints, equipment and tooling constraints, or Human Factor requests.

Such manufacturing requirements may have implications for product design. However, manufacturing requirements derived from 3D specifications typically only flow down to manufacturing operations. Traditionally, feedback from manufacturing can be late and only done through engineering and stakeholder design review meetings, siloed spreadsheet or document design review checklists, or Manufacturing (or other domains like Human Factors) change requests or risk item reports. All methods require humans to identify the risk or opportunity by reviewing the specification themselves and either using their expertise knowledge or reference material as disconnected data.

### SUMMARY

An illustrative embodiment provides a computer-implemented method of manufacturing analysis. The method comprises identifying a feature of a product model defined by geometric, physical, and systems elements with semantic labels, names or title descriptions. Machine readable semantic links are created that connect the feature to elements in an enterprise knowledge library according to a machine readable ontological knowledge model. A producibility risk or opportunity for the product model is identified according to semantic relationships of the elements in the enterprise knowledge library linked to the feature. A user is alerted of the producibility risk or opportunity, and a note is added to a manufacturing design specification for the product model. The note provides a number of solutions for the producibility risk or opportunity, wherein the solutions are identified in the enterprise knowledge library according to the semantic relationships.

Another illustrative embodiment provides a system for manufacturing analysis. The system comprises a storage device that stores program instructions and one or more processors operably connected to the storage device and configured to execute the program instructions to cause the system to: identify a feature of a product model defined by geometric, physical, and systems elements with semantic labels, names or title descriptions; create machine readable semantic links that connect the feature to elements in an enterprise knowledge library according to a machine readable ontological knowledge model; identify a producibility risk or opportunity for the product model according to semantic relationships of the elements in the enterprise knowledge library linked to the feature; alert a user of the producibility risk or opportunity; and add a note to a manufacturing design specification for the product model, wherein the note provides a number of solutions for the producibility risk or opportunity, wherein the solutions are identified in the enterprise knowledge library according to the semantic relationships.

Another illustrative embodiment provides a computer program product for manufacturing analysis. The compute program product comprises a computer-readable storage medium having program instructions embodied thereon to perform the operations of: identifying a feature of a product model defined by geometric, physical, and systems elements with semantic labels, names or title descriptions; creating machine readable semantic links that connect the feature to elements in an enterprise knowledge library according to a machine readable ontological knowledge model; identifying a producibility risk or opportunity for the product model according to semantic relationships of the elements in the enterprise knowledge library linked to the feature; alerting a user of the producibility risk or opportunity; and adding a note to a manufacturing design specification for the product model, wherein the note provides a number of solutions for the producibility risk or opportunity, wherein the solutions are identified in the enterprise knowledge library according to the semantic relationships.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** is a pictorial representation of a network of data processing systems in which illustrative embodiments can be implemented;
**Figure 2** is an illustration of a block diagram of a manufacturing analysis system in accordance with an illustrative embodiment;
**Figure 3** illustrates the relationship between a product model and manufacturing process steps in accordance with an illustrative embodiment;
**Figure 4** depicts a production system model in accordance with an illustrative embodiment;
**Figure 5** depicts a semantic knowledge graph in accordance with an illustrative embodiment;
**Figure 6** depicts a knowledge table in accordance with an illustrative embodiment;
**Figure 7** depicts an alert and resolution table superimposed on the production system model in accordance with an illustrative embodiment;
**Figure 8** depicts an alert and resolution graph superimposed on the production system model in accordance with an illustrative embodiment;
**Figure 9** shows the application of data graphs to product development specifications in accordance with an illustrative embodiment;
**Figure 10** depicts a flowchart of a process for manufacturing analysis in accordance with an illustrative embodiment; and
**Figure 11** is an illustration of a block diagram of a data processing system in accordance with an illustrative embodiment.

### DETAILED DESCRIPTION

The illustrative embodiments recognize and take into account that manufacturing requirements are often derived from 3D specifications used in computer-aided modeling, and such manufacturing requirements may have implications for product design.

The illustrative embodiments also recognize and take into account that manufacturing requirements derived from 3D modeling specifications and annotations typically only flow down to manufacturing operations.

The illustrative embodiments provide a method to flow requirements from downstream domains such as manufacturing, human factors, equipment engineering, and tooling engineering back to the product design stage. This flow back process allows design engineers to take remedial action to the product standards or product design. The illustrative embodiments also integrate design and product data to identify production risks and opportunities and provide solutions.

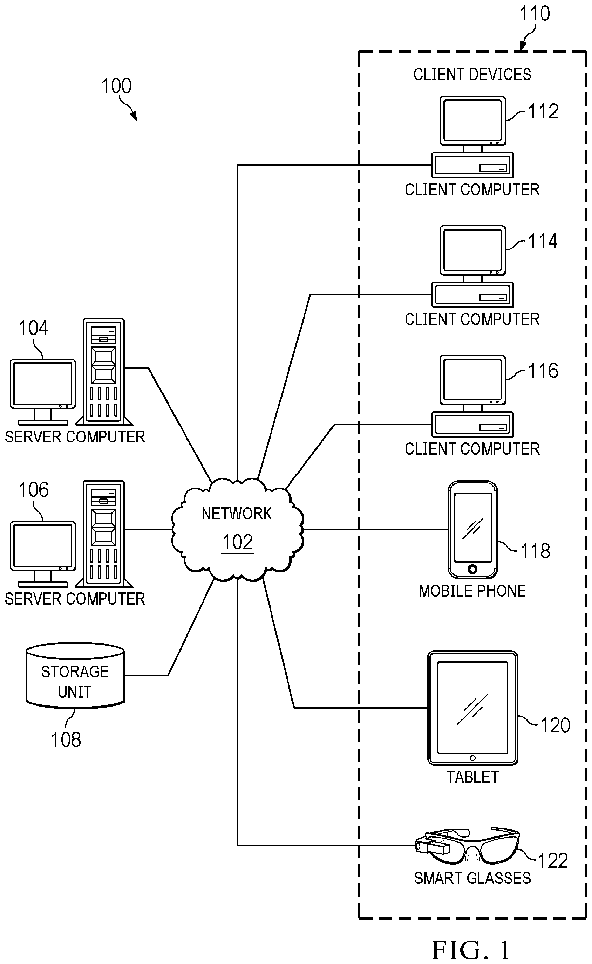

With reference to **Figure 1****,** a pictorial representation of a network of data processing systems is depicted in which illustrative embodiments may be implemented. Network data processing system **100** is a network of computers in which the illustrative embodiments may be implemented. Network data processing system **100** contains network **102,** which is the medium used to provide communications links between various devices and computers connected together within network data processing system **100.** Network **102** might include connections, such as wire, wireless communication links, or fiber optic cables.

In the depicted example, server computer **104** and server computer **106** connect to network **102** along with storage unit **108.** In addition, client devices **110** connect to network **102.** In the depicted example, server computer **104** provides information, such as boot files, operating system images, and applications to client devices **110.** Client devices **110** can be, for example, computers, workstations, or network computers. As depicted, client devices **110** include client computers **112, 114,** and **116.** Client devices **110** can also include other types of client devices such as mobile phone **118,** tablet computer **120,** and smart glasses **122.**

In this illustrative example, server computer **104,** server computer **106,** storage unit **108,** and client devices **110** are network devices that connect to network **102** in which network **102** is the communications media for these network devices. Some or all of client devices **110** may form an Internet of things (IoT) in which these physical devices can connect to network **102** and exchange information with each other over network **102.**

Client devices **110** are clients to server computer **104** in this example. Network data processing system **100** may include additional server computers, client computers, and other devices not shown. Client devices **110** connect to network **102** utilizing at least one of wired, optical fiber, or wireless connections.

Program code located in network data processing system **100** can be stored on a computer-recordable storage medium and downloaded to a data processing system or other device for use. For example, the program code can be stored on a computer-recordable storage medium on server computer **104** and downloaded to client devices **110** over network **102** for use on client devices **110.**

In the depicted example, network data processing system **100** is the Internet with network **102** representing a worldwide collection of networks and gateways that use the Transmission Control Protocol/Internet Protocol (TCP/IP) suite of protocols to communicate with one another. At the heart of the Internet is a backbone of high-speed data communication lines between major nodes or host computers consisting of thousands of commercial, governmental, educational, and other computer systems that route data and messages. Of course, network data processing system **100** also may be implemented using a number of different types of networks. For example, network **102** can be comprised of at least one of the Internet, an intranet, a local area network (LAN), a metropolitan area network (MAN), or a wide area network (WAN). **Figure 1** is intended as an example, and not as an architectural limitation for the different illustrative embodiments.

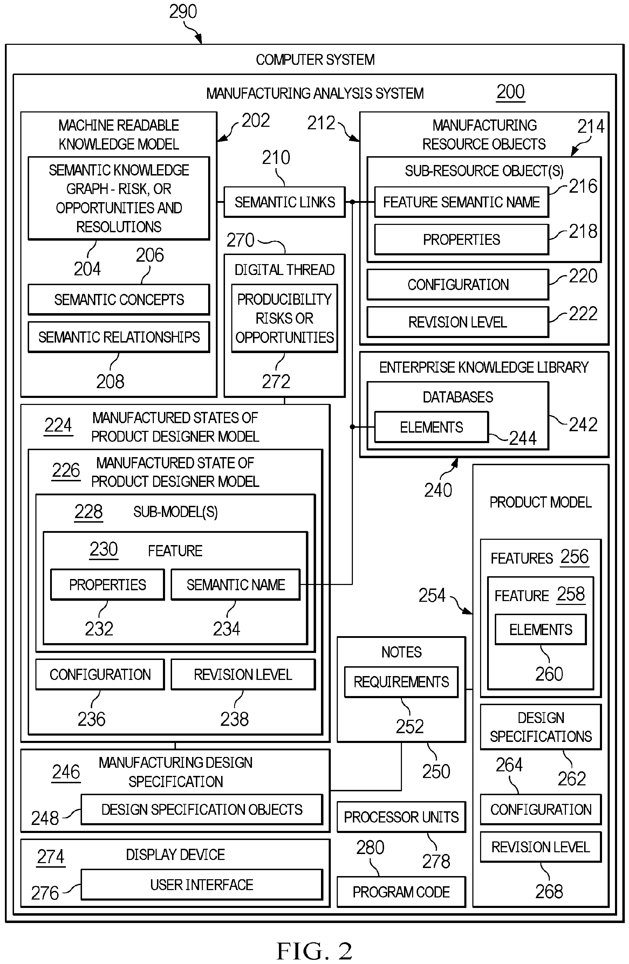

With reference now to **Figure 2****,** an illustration a block diagram of a manufacturing analysis system is depicted in accordance with an illustrative embodiment. In this illustrative example, manufacturing analysis system **200** includes components that can be implemented in hardware such as the hardware shown in network data processing system **100** in **Figure 1****.**

Manufacturing analysis system **200** comprises a machine readable knowledge model **202** that provides an ontological framework for establishing semantic connections between an article of manufacture and cumulative, dispersed enterprise knowledge related to production methods and available manufacturing resources. Machine readable knowledge model **202** might be presented as a semantic knowledge graph **204,** which can be displayed by display device **274.** Machine readable knowledge model **202** comprise a number of semantic concepts **206** related to an article of manufacture and methods and resources for manufacturing it and models semantic relationships **208** between those semantic concepts.

Manufacturing analysis system **200** also comprises a manufacturing resource object **212** which might represent a production system model related to manufacturing resources used to produce an article of manufacture. Manufacturing resource object **212** might comprise a number of sub-resource objects **214.** Each sub-resource object **214** comprises a number of properties **218** and a feature semantic name **216.** Manufacturing resource object **212** might represent a specific configuration **220** and revision level **222** for the article of manufacture in question. As the configuration **220** and revision level **222** change so might the sub-resource object(s) **214** comprising the manufacturing resource object **212.**

Manufacturing analysis system **200** comprises an enterprise knowledge library **240** that includes a number of databases **242** relevant to designing and producing the article of manufacture. Enterprise knowledge library **240** brings together cumulative and dispersed institutional knowledge related to manufacturing methods, resources, articles of manufacture, etc., as well as risks and opportunities for improvement related to these categories based on past experience. Enterprise knowledge library **240** can be continually updated.

Enterprise knowledge library **240** pulls together several databases **242** comprising elements **244.** For example, databases **242** might include a database for manufacturing processes and process standards relevant to a feature, part, object or assembly of objects. Databases **242** might also include a database of design guidance, manuals, recommendations, checklists, processes, and practices. Another example is a database of manufacturing assets relevant to manufacturing processes for an article of manufacture. Another example is a database of previously-identified non-conformances, defects, failure modes effect analysis, or risks relevant to manufacturing processes for the article of manufacture and means of resolution or improvement of the processes. Databases **242** might also include a database of formally modeled, machine-readable ontologies unique to a company's intellectual property, research, interests and business, and industry standards.

The article of manufacture in question is represented by product model **254,** which comprises a number of defining features **256.** Each feature **258** of the features 256 comprises a number functional or physical, structural, geometric elements **260.** Features **256** are determined by design specifications **262** and a configuration **236** of the article of manufacture, which may change according to the revision level **268** of the design of the article.

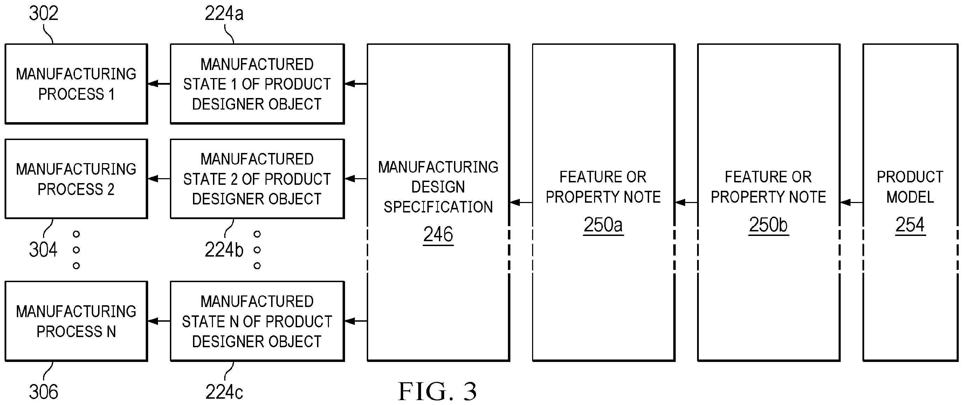

Product model **254** is converted to a manufacturing design specification **246** comprising a number of design specification objects **248** such as would be used in computer aided design (CAD) and requirements modeling. The manufacturing design specification **246** can be used to define a number of manufactured states **224** of product model **254** (see **Figure 3**). Each manufactured state **226** represents a different step in the manufacturing process for the product model **254,** which is subject to change according to a configuration **236** and revision level **238,** which correspond to the configuration **264** and revision level **268** of the product model **254.**

A manufactured state **226** relates to a number of sub-objects **228** that might be added, removed, modified, etc., regarding a feature **230** corresponding to feature **258** of the product model **254.** Feature **230** includes properties **232** and a semantic name **234.**

Machine readable knowledge model **202** provides an ontological framework for creating machine readable semantic links **210** that connect and interrelate the manufacturing resource object **212,** enterprise knowledge library **240,** and product model **254** (via manufactured states **224** and manufacturing design specification **246**). The semantic links **210** add context to the model represented by manufacturing design specification **246** based on classifications in the enterprise knowledge library **240.**

Through this context, semantic links **210** facilitate the identification of potential producibility risks or opportunities for improvement to a production process/model based on past experience and institutional know how recorded in the enterprise knowledge library **240.** The producibility risks or opportunities can be brought to the attention of a user via user interface **276** in display device **274.**

The identification of these producibility risks or opportunities leads to the creation of notes **250** comprising requirements **252** that can be added to the manufacturing design specification **246** as new design specification objects **248.** Note **250** is from Manufacturing Engineering to make the product model **254** more producible. This note **250** can constrain and cause changes to the features **256,** design specifications **262,** configuration **264** and consequently revision level **268.** Notes **250** from Manufacturing/Production Engineering can go either way. It can flow requirements to the product model **254** and then into the manufactured states **224** of product model.

The program code **280** and processor units **278** can use generative artificial intelligence (AI) to make suggestions which turn into design specification objects **248.** A user might read the suggestion from the generative AI code, and then write a design specification object/suggestion to the product model **254.** Alternatively, a generative AI script can provide a design specification object **248** from the databases **242.** As the information and generative AI code becomes more precise and accurate the production system and articles of manufacture (e.g., aircraft, automobiles, etc.) can be modeled and designed automatically through semantic search via semantic links. AI algorithms can be trained to provide increasingly better suggestions, allowing design and modeling to move from focus on singular elements to larger more complex solutions models. Manufacturing analysis system **200** generates a digital thread **270** that collects the producibility risks or opportunities **272** and measured criteria relevant to the producibility risks or opportunities and links them to a final product for quality assurance.

The display device **274** can include at least one of a light emitting diode (LED) display, a liquid crystal display (LCD), an organic light emitting diode (OLED) display, a computer monitor, a projector, a flat panel display, a heads-up display (HUD), a head-mounted display (HMD), or some other suitable device that can output information for the visual presentation of information. Manufacturing analysis system **200** can be implemented in software, hardware, firmware, or a combination thereof. When software is used, the operations performed by manufacturing analysis system **200** can be implemented in program code configured to run on hardware, such as a processor unit. When firmware is used, the operations performed by manufacturing analysis system **200** can be implemented in program code and data and stored in persistent memory to run on a processor unit. When hardware is employed, the hardware can include circuits that operate to perform the operations in manufacturing analysis system **200.**

In the illustrative examples, the hardware can take a form selected from at least one of a circuit system, an integrated circuit, an application specific integrated circuit (ASIC), a programmable logic device, or some other suitable type of hardware configured to perform a number of operations. With a programmable logic device, the device can be configured to perform the number of operations. The device can be reconfigured at a later time or can be permanently configured to perform the number of operations. Programmable logic devices include, for example, a programmable logic array, a programmable array logic, a field programmable logic array, a field programmable gate array, and other suitable hardware devices. Additionally, the processes can be implemented in organic components integrated with inorganic components and can be comprised entirely of organic components excluding a human being. For example, the processes can be implemented as circuits in organic semiconductors.

Computer system **290** is a physical hardware system and includes one or more data processing systems. When more than one data processing system is present in computer system **290,** those data processing systems are in communication with each other using a communications medium. The communications medium can be a network. The data processing systems can be selected from at least one of a computer, a server computer, a tablet computer, or some other suitable data processing system.

As depicted, computer system **290** includes a number of processor units **278** that are capable of executing program code **280** implementing processes in the illustrative examples. As used herein a processor unit in the number of processor units **278** is a hardware device and is comprised of hardware circuits such as those on an integrated circuit that respond and process instructions and program code that operate a computer. When a number of processor units **278** execute program code **280** for a process, the number of processor units **278** is one or more processor units that can be on the same computer or on different computers. In other words, the process can be distributed between processor units on the same or different computers in a computer system. Further, the number of processor units **278** can be of the same type or different type of processor units. For example, a number of processor units can be selected from at least one of a single core processor, a dual-core processor, a multiprocessor core, a general-purpose central processing unit (CPU), a graphics processing unit (GPU), a digital signal processor (DSP), or some other type of processor unit. The Manufacturing Analysis System **200** helps to digitally thread and make more visible and useful the manufacturing quality challenges detected, resolved, and reported in siloed databases. The following examples help illustrate the application of manufacturing analysis system **200.**

The first example is the application of a non-destructive inspection (NDI) ultrasonic, water coupling pulse echo system to a composite panel for defects. A feature on that composite panel may become curved, wavey, or bumpy during manufacturing. This knowledge is captured in the Machine Readable Knowledge Model **202** and Enterprise Knowledge Library **240** and not specified or known within the Product Model **254** and Manufactured States of Product Model **224.** The inspectability risk here is that the end of the probe can trip over bumps if on the near-side surface or lose the signal as it echoes off the farside surface that is too wavey.

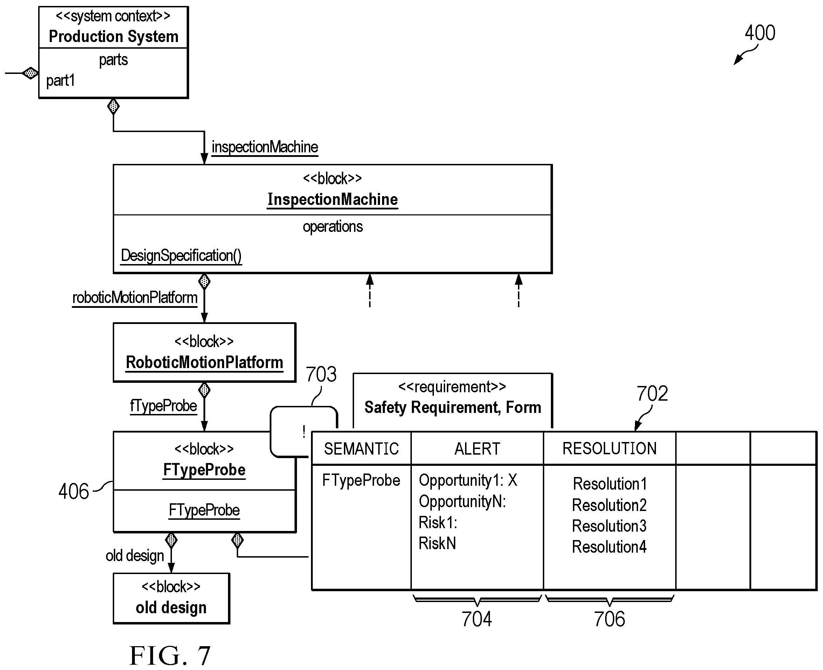

The semantic knowledge graph **204** can associate this issue with the cause of the bumps and waves, which can be a Manufacturing Resource Object **212.** The Manufacturing Resource Object **212** semantics will highlight in multiples ways (e.g., semantic phrase or alert **703** in **Figure 7**) and one can click on the semantic phrase or alert **703** to see the Resolution Table **702** which shows potential producibility risks or opportunities **704** (see **Figure 7**). A risk **704** can show that the NDI system cannot scan over certain types of waves and bumps and will recommend a resolution **706.** One can realize the suggested resolution by turning it into a Note **250** from Resolution **706.** The Note **250** can be a natural language text description with images, process instructions, a standard structured text specification, programming code, or a parametric value, array or equation. The Note **250** can be referenced as an instance within the specification of the design specification **248** of Manufacturing Design Specification **246** or the design specification **262** of Product Model **254.** Another similar example is the application of a non-destructive inspection (NDI) ultrasonic, water coupling, pulse echo inspection system, wherein the backside surface of a composite panel is wet. In this situation, the water can interfere with the return of the ultrasonic signals, leading to a corrupted or distorted return signals. This corrupted signal data can affect the accuracy and reliability of defect detection in the composite panel. Again, this knowledge is captured in the Machine Readable Knowledge Model **202** and Enterprise Knowledge Library **240** and not necessarily specified within the Manufactured States of Product Model **224.** The inspectability risk here is that during inspection scanning, the backside surface needs to be dry. The semantic knowledge graph **204** can associate this issue by suggesting a Resolution **706,** which can be a Note **250** for the Manufacturing Design Specification **246,** which will specify requirements for Manufactured Stated of Product Model **224** to be dry on back-side surface during NDI scanning. Manufacturing Operations can define requirements for a Manufacturing Resource Object **212** to keep the backside surface dry. Therefore, the Manufacturing Resource Object **212** can be a water shield or tools to blow dry the backside surface.

The above examples illustrate the ability of the illustrative embodiments to integrate information from historically isolated information sources into actionable information that is unaccounted for in product models and would otherwise be omitted from manufacturing design specifications and manufacturing procedures for a product.

**Figure 3** illustrates the relationship between a product model and manufacturing process steps in accordance with an illustrative embodiment. Product model **254** is converted to a manufacturing design specification **246** (i.e., CAD model). A number of manufactured states **224a-224c** are derived from the manufacturing design specifications **246,** corresponding to respective manufacturing processes **302-306** for different production stages of the article of manufacture represented by the product model **254.**

A number of feature or property notes **250a-250b** can be added to constrain the manufacturing design specifications **246** according to the identification of producibility risks or opportunities identified from the enterprise knowledge library. There might be any number of feature or property notes at different levels of granularity of the product model.

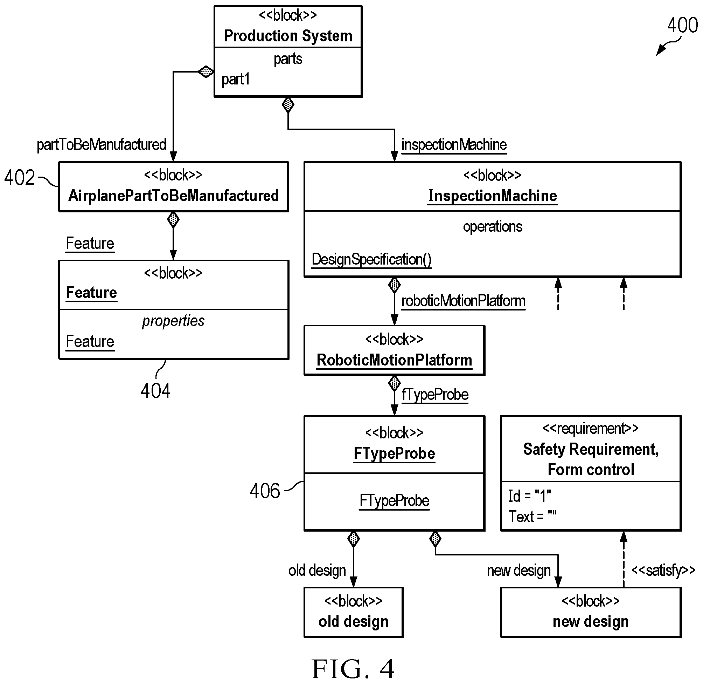

**Figure 4** depicts a production system model in accordance with an illustrative embodiment. Production system model **400** might be represented by manufactured states **224** of product models and manufacturing resource objects **212** in **Figure 2****.**

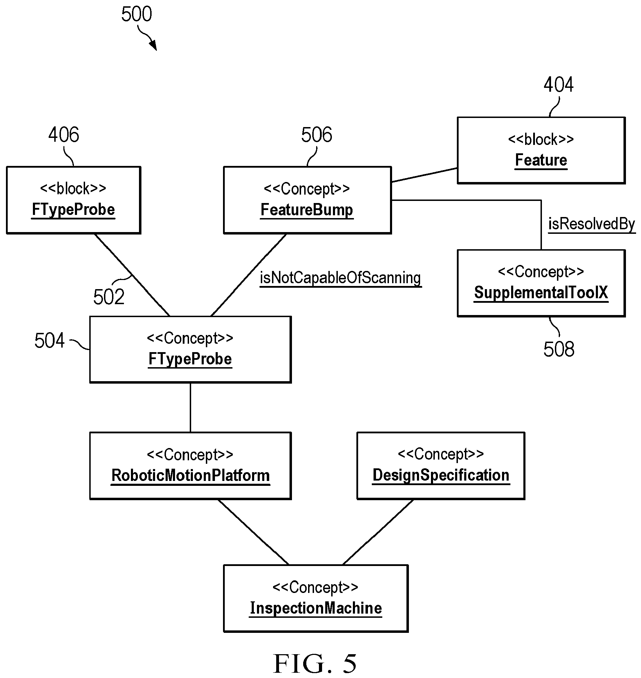

The example production system model **400** shown in **Figure 4** is present using systems modeling language (SysML). In the present example, production system model **400** relates to an airplane part **402** to be manufactured. A feature of this part has been identified as a feature component **404.** This feature component **404** needs to be integrated with an F-type probe **406.** These feature integration risks may not be known in advance. However, preexisting information in manufacturing databases can flag this issue through knowledge graphs. **Figure 5** depicts a semantic knowledge graph in accordance with an illustrative embodiment. Knowledge graph **500** might be an example of semantic knowledge graph **202** in **Figure 2****.**

Semantic knowledge graph **500** is represented as a graph with nodes and edges which can be displayed to a user in a graphical user interface such as user interface **276** in **Figure 2****.**

**Figure 5** illustrates an example of how a user can navigate from production system model. Production system model **400** has a <<Block>> **406** in SysML language with semantic name FTypeProbe. (In **Figure 2****,** this block would constitute a feature semantic name **216**.) Semantic link **502** links <<Block>> **406** to <<Concept>> FTypeProbe **504** in the semantic knowledge graph **500.**

The semantics from <<Concept>> FTypeProbe **504** to isNotCapableOfScanning for semantic concept <<Concept>> Feature **506.** <<Concept>> Feature **506** in turn is semantically linked to semantic concept <<Concept>> SupplementalToolX **508.** If that semantic concept is linked to other semantics in the model, the user can navigate into the enterprise knowledge library and databases, which might contain risk elements and resolution elements (example of elements **244** in **Figure 2**). They can have the semantics SupplementalToolX.

The illustrative embodiments can analyze semantic features that are known to have issues that have been discovered in the past through testing on characteristics that do show up in the model, and therefore need to be controlled through notes. While CAD does specify parametric features like points, lines, planes and solids, the semantics on those features can provide hints to manufacturing quality characteristics that are also problematic that can be resolved through additional notes (not necessarily direct, parametric design changes).

For example, manufacturing quality of co-cured vents leads to resin ridges around caul plates, which is not explicitly known or specified in CAD GD&T (Geometric Dimensioning and Tolerancing). This effect is known through testing and controlled through design guidance, notes, which can eventually lead to Caul Plate geometric design optimization to reduce thickness along edges that lead to resin build up. Alternatively, it can specify a sanding operation after debag, to get rid of all the bumps before NDI, so that the probes don't get snagged. This knowledge is buried in R&D documents siloed on servers. The illustrative embodiments find a way to link those pieces of information to relevant terms a product modeler might put on a new product model.

As another example, manufacturing quality of a composite wing panel can have the backside surface wet for a variety of reasons which is not favorable when NDI pulse echo scanning methods are used on the front side. For example, a wash situation prior to NDI can leave the back side wet if not dried in advance. Or the water used as a couplant during NDI gets splashed and dripping down the backside surface. The semantic knowledge graph can pick this up and warn the production system designer to design features to block water from getting to the back side or to wipe and dry the back side with a variety of tools and methods prior to NDI scan.

In some cases, the enterprise knowledge library might have billions of elements related to the same single semantic phrase. Therefore, model context and specific semantics and definition/meaning can be used to narrow down relevant elements. Advance scripts can be written to filter the relationships.

There are many variants to navigating the semantics links to see risk or opportunity and the resolution that comes along with it. A user can manually point, click, and look for meaningful, relevant information. Scripts can filter a portion of relation. Program code might automatically look at model context and the semantic knowledge, enterprise knowledge library, databases, of all models, and find relevant suggestions for the user on risk and resolution elements. This process might be performed by a background manufacturing analysis engine that is continuously flagging or suggesting ideas in the model.

The program code can be smart enough to see that a manufacturing resource object **212** (e.g., FTypeProbe) cannot scan a manufactured state **226** of a product model **254** (e.g., Feature), and search the enterprise knowledge library **240** and databases **242** to find a SupplementalToolX and design specification object elements.

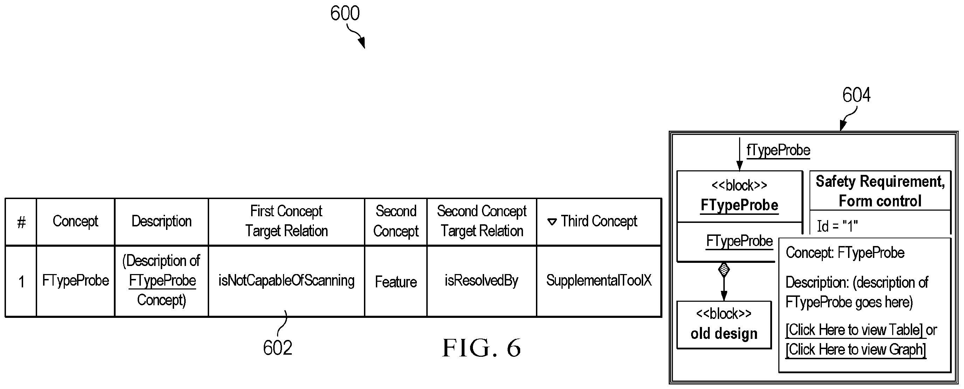

**Figure 6** depicts a knowledge table in accordance with an illustrative embodiment. Knowledge table **600** is an alternate presentation of machine readable knowledge model **202** in **Figure 2****.**

Also shown is a description window **604,** which can be called up by the user by clicking on or hovering over an active semantic link related to the description of a concept/phrase in knowledge table **600.** In the example shown, the semantic link **602** (represented by underlining) and description window **604** are related to the F-type probe. It should be noted that similar active semantic links pop up description windows can be employed with semantic knowledge graph **500.**

A glossary profile allows a user to link across a model (which can be any type of model, such as a logical block model or CAD model with semantics/phrases) to a semantic knowledge graph such as semantic knowledge graph **500.**

In addition to showing the definition of the concept/phrase in question, description window **604** can also relate producibility risks or opportunities to the term.

**Figure 7** depicts an alert and resolution table superimposed on the production system model in accordance with an illustrative embodiment. This example illustrates the use of a semantic link in the production system model **400** related to the F-type probe **406.** By clicking or hovering over the link, alert **703** and resolution table **702** appears, which includes a number of potential risks and opportunities **704** related to the F-type probe **406.** Alternatively, alert **703** may already be displayed in the model across different concepts/phrase on the object/model and hovering over the alert to call up the resolution table **702.** Also shown in description alert and resolution table **702** are corresponding resolution processes **706** to address each of the risks or opportunities **704.**

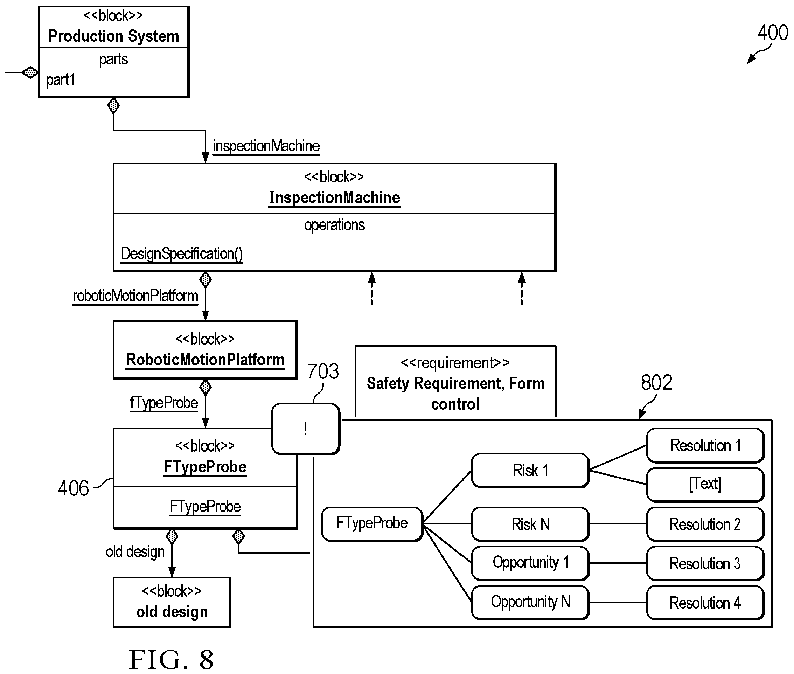

**Figure 8** depicts an alert and resolution graph superimposed on the production system model in accordance with an illustrative embodiment. The example shown in

**Figure 8** is substantively similar to that shown in **Figure 7****.** In this example, activating the semantic link related to the F-type probe **406** in production system model **400** calls up alert **703** and resolution graph **802,** which presents the same information as that shown in alert and resolution table **702** in **Figure 7****.** Similar to **Figure 7****,** alert **703** may also already be displayed in the model across different concepts/phrase on the object/model and hovering over the alert to call up the resolution table **802.** Generative AI might also be activated to present high priority alerts, as well as color code them, depending on the level of sensitivity or criticality of risks that need to be presented.

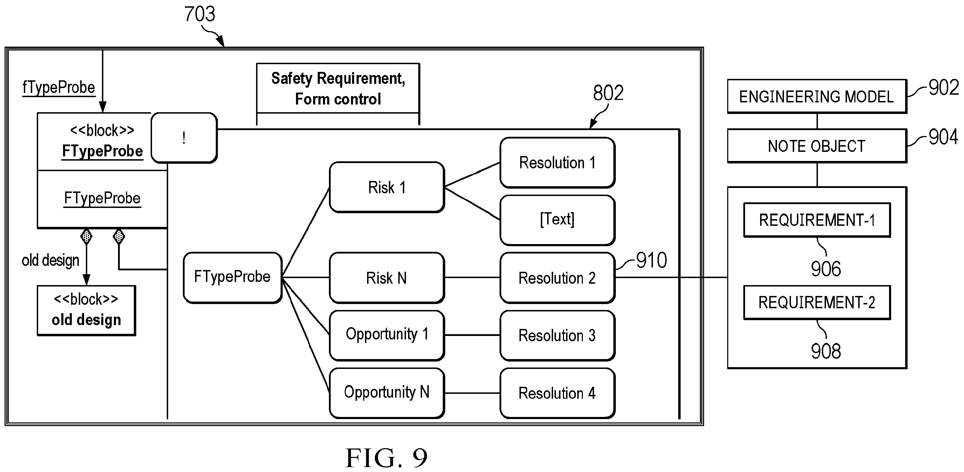

**Figure 9** shows the application of data graphs to product development specifications in accordance with an illustrative embodiment. Once a relevant risk or opportunity is identified for a feature, a note object **904** (note **250**) can be created within the product design model **902.**

Identifying and reusing risk or issue objects from alert and resolution graph **802** can speed up the development process and improve quality of risk analysis by finding a relevant solution if it already exists in the knowledge base. The user can use resolutions from alert **703** and resolution graph **802** to create design requirement objects **906, 908,** which are then imported into the product development engineering model **902** to specify a design solution and retire a risk or capture an opportunity. In this context, the solution is coming from manufacturing to make the product design more producible.

Therefore, the resolution **910** to a risk from alert **703** and resolution graph **802** can become part of the design requirements and can be reused from one development program to another.

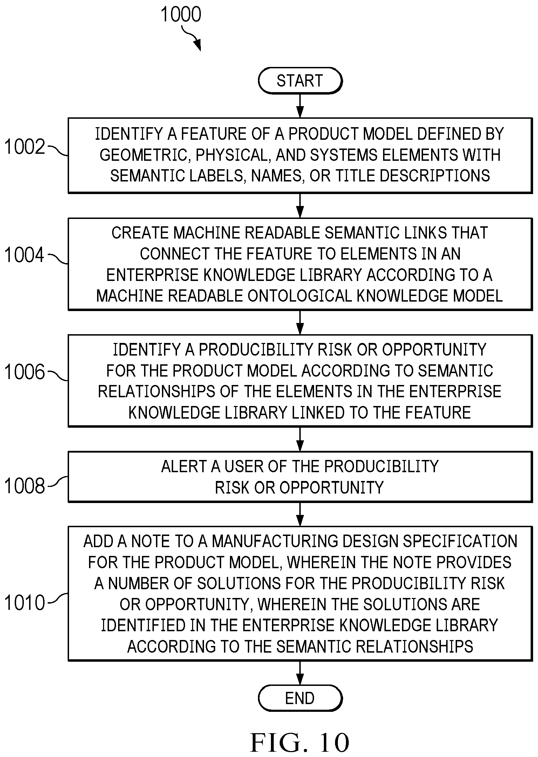

**Figure 10** depicts a flowchart of a process for manufacturing analysis in accordance with an illustrative embodiment. The process in **Figure 10** can be implemented in hardware, software, or both. When implemented in software, the process can take the form of program code that is run by one of more processor units located in one or more hardware devices in one or more computer systems. For example, the process can be implemented in manufacturing analysis system **200** in computer system **290** in **Figure 2****.**

Process **1000** begins by identifying a feature of a product model defined by geometric, physical, and systems elements with semantic labels, names or title descriptions (operation **1002**). The feature of the producer object might comprise an entity within a computer aided design (CAD) environment that defines geometric or functional portion of a part. Examples of features might include Package folder, Collector, System Block, Behavior, Object, Object Property, Object Method, Physical product, Part, 3D Shape specification, Annotation set, Note, points, lines, planes, curves, surfaces, or solid shapes.

The geometric, physical, and systems elements of the feature might include material properties, ply stack thickness, radius of curvature, manufacturing features (e.g., required excess), manufacturing quality; manufacturing tools, machining specifications, painting specifications, inspection specifications, wash and dry processes index tool coordination features, tool coordination, geometric dimensioning and tolerancing, transportation, handling, and logistic features.

Process **1000** creates machine readable semantic links that connect the feature to elements in an enterprise knowledge library according to a machine readable ontological knowledge model (operation **1004**). The manufacturing process library might be comprised of a number of databases. These databases might include, for example, a database of manufacturing processes and process standards relevant to a feature, part, object or assembly of objects, a database of design guidance, manuals, recommendations, checklists, processes, and practices, a database of manufacturing assets relevant to manufacturing processes for the object, a database of previously-identified non-conformances, defects, failure modes effect analysis, or risks relevant to manufacturing processes for the object and means of resolution or improvement of the processes, and a database of formally modeled, machine-readable ontologies unique to a company's intellectual property, research, interests and business, and industry standards.

Process **1000** identifies a producibility risk or opportunity for the product model according to semantic relationships of the elements in the enterprise knowledge library linked to the feature (operation **1006**). Identifying the producibility risk or opportunity for the product model of might be performed through semantic analysis of the enterprise knowledge library. Identifying the producibility risk or opportunity might be performed via natural language processing (NLP). A digital thread can be used to collect and link the producibility risk or opportunity, and measured criteria relevant to the producibility risk or opportunity, to a final product for quality assurance.

Process **1000** alerts a user of the producibility risk or opportunity (operation **1008**).

Process **1000** adds a note to a manufacturing design specification for the product model, wherein the note provides a number of solutions for the producibility risk or opportunity, wherein the solutions are identified in the enterprise knowledge library according to the semantic relationships, thereby integrating information from the enterprise knowledge library into actionable information that is unaccounted for in the product model and would otherwise be omitted the from manufacturing design specification (operation **1010**).

The solutions for the producibility risk or opportunity comprise at least one of a change of design specifications of the object or a change of configuration of the object. Examples of design specifications or configurations that might be changed include material properties, ply stack thickness, radius of curvature, manufacturing features (e.g., required excess), manufacturing quality; manufacturing tools, machining specifications, painting specifications, inspection specifications, wash and dry processes index tool coordination features, tool coordination, geometric dimensioning and tolerancing, transportation, handling, and logistic features.

Process **1000** then ends.

The flowchart and block diagrams in the different depicted embodiments illustrate the architecture, functionality, and operation of some possible implementations of apparatuses and methods in an illustrative embodiment. In this regard, each block in the flowcharts or block diagrams can represent at least one of a module, a segment, a function, or a portion of an operation or step. For example, one or more of the blocks can be implemented as program code, hardware, or a combination of the program code and hardware. When implemented in hardware, the hardware can, for example, take the form of integrated circuits that are manufactured or configured to perform one or more operations in the flowcharts or block diagrams. When implemented as a combination of program code and hardware, the implementation may take the form of firmware. Each block in the flowcharts or the block diagrams can be implemented using special purpose hardware systems that perform the different operations or combinations of special purpose hardware and program code run by the special purpose hardware.

In some alternative implementations of an illustrative embodiment, the function or functions noted in the blocks may occur out of the order noted in the figures. For example, in some cases, two blocks shown in succession may be performed substantially concurrently, or the blocks may sometimes be performed in the reverse order, depending upon the functionality involved. Also, other blocks may be added in addition to the illustrated blocks in a flowchart or block diagram.

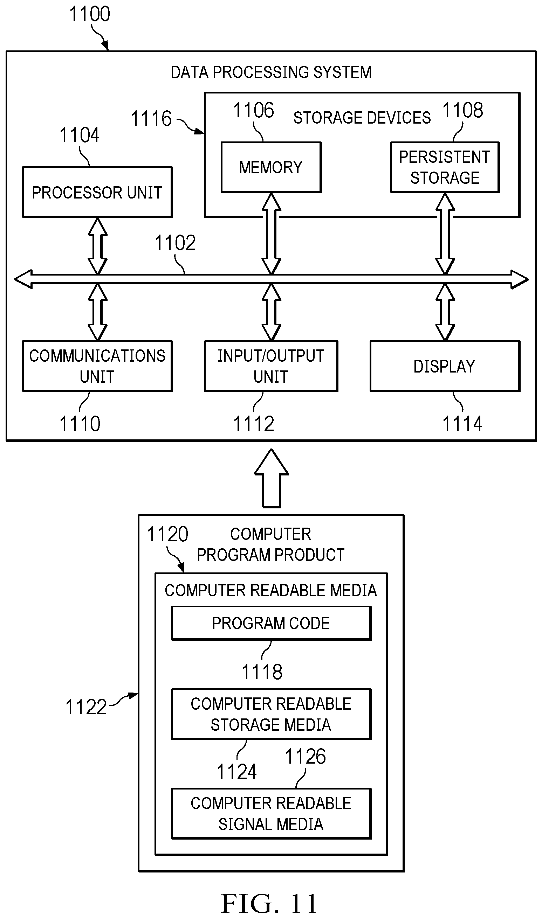

Turning now to **Figure 11****,** an illustration of a block diagram of a data processing system is depicted in accordance with an illustrative embodiment. Data processing system **1100** may be used to implement server computers **104** and **106** and client devices **110** in **Figure 1****,** as well as computer system **290** in **Figure 2****.** In this illustrative example, data processing system **1100** includes communications framework **1102,** which provides communications between processor unit **1104,** memory **1106,** persistent storage **1108,** communications unit **1110,** input/output (I/O) unit **1112,** and display **1114.** In this example, communications framework **1102** takes the form of a bus system.

Processor unit **1104** serves to execute instructions for software that may be loaded into memory **1106.** Processor unit **1104** may be a number of processors, a multiprocessor core, or some other type of processor, depending on the particular implementation. In an embodiment, processor unit **1104** comprises one or more conventional general-purpose central processing units (CPUs). In an alternate embodiment, processor unit **1104** comprises one or more graphical processing units (GPUs). Memory **1106** and persistent storage **1108** are examples of storage devices **1116.** A storage device is any piece of hardware that is capable of storing information, such as, for example, without limitation, at least one of data, program code in functional form, or other suitable information either on a temporary basis, a permanent basis, or both on a temporary basis and a permanent basis. Storage devices **1116** may also be referred to as computer-readable storage devices in these illustrative examples. Memory **1106,** in these examples, may be, for example, a random access memory or any other suitable volatile or non-volatile storage device. Persistent storage **1108** may take various forms, depending on the particular implementation.

For example, persistent storage **1108** may contain one or more components or devices. For example, persistent storage **1108** may be a hard drive, a flash memory, a rewritable optical disk, a rewritable magnetic tape, or some combination of the above. The media used by persistent storage **1108** also may be removable. For example, a removable hard drive may be used for persistent storage **1108.** Communications unit **1110,** in these illustrative examples, provides for communications with other data processing systems or devices. In these illustrative examples, communications unit **1110** is a network interface card.

Input/output unit **1112** allows for input and output of data with other devices that may be connected to data processing system **1100.** For example, input/output unit **1112** may provide a connection for user input through at least one of a keyboard, a mouse, or some other suitable input device. Further, input/output unit **1112** may send output to a printer. Display **1114** provides a mechanism to display information to a user.

Instructions for at least one of the operating system, applications, or programs may be located in storage devices **1116,** which are in communication with processor unit **1104** through communications framework **1102.** The processes of the different embodiments may be performed by processor unit **1104** using computer-implemented instructions, which may be located in a memory, such as memory **1106.**

These instructions are referred to as program code, computer-usable program code, or computer-readable program code that may be read and executed by a processor in processor unit **1104.** The program code in the different embodiments may be embodied on different physical or computer-readable storage media, such as memory **1106** or persistent storage **1108.**

Program code **1118** is located in a functional form on computer-readable media **1120** that is selectively removable and may be loaded onto or transferred to data processing system **1100** for execution by processor unit **1104.** Program code **1118** and computer-readable media **1120** form computer program product **1122** in these illustrative examples. In one example, computer-readable media **1120** may be computer-readable storage media **1124** or computer-readable signal media **1126.**

In these illustrative examples, computer-readable storage media **1124** is a physical or tangible storage device used to store program code **1118** rather than a medium that propagates or transmits program code **1118.** Computer readable storage media **1124,** as used herein, is not to be construed as being transitory signals *per se,* such as radio waves or other freely propagating electromagnetic waves, electromagnetic waves propagating through a waveguide or other transmission media (e.g., light pulses passing through a fiber-optic cable), or electrical signals transmitted through a wire, as used herein, is not to be construed as being transitory signals *per se,* such as radio waves or other freely propagating electromagnetic waves, electromagnetic waves propagating through a waveguide or other transmission media (e.g., light pulses passing through a fiber-optic cable), or electrical signals transmitted through a wire. Alternatively, program code **1118** may be transferred to data processing system **1100** using computer-readable signal media **1126.** Computer-readable signal media **1126** may be, for example, a propagated data signal containing program code **1118.** For example, computer-readable signal media **1126** may be at least one of an electromagnetic signal, an optical signal, or any other suitable type of signal. These signals may be transmitted over at least one of communications links, such as wireless communications links, optical fiber cable, coaxial cable, a wire, or any other suitable type of communications link.

The different components illustrated for data processing system **1100** are not meant to provide architectural limitations to the manner in which different embodiments may be implemented. The different illustrative embodiments may be implemented in a data processing system including components in addition to or in place of those illustrated for data processing system **1100.** Other components shown in **Figure 11** can be varied from the illustrative examples shown. The different embodiments may be implemented using any hardware device or system capable of running program code **1118.**

As used herein, the phrase "at least one of," when used with a list of items, means different combinations of one or more of the listed items can be used, and only one of each item in the list may be needed. In other words, "at least one of" means any combination of items and number of items may be used from the list, but not all of the items in the list are required. The item can be a particular object, a thing, or a category.

For example, without limitation, "at least one of item A, item B, or item C" may include item A, item A and item B, or item B. This example also may include item A, item B, and item C or item B and item C. Of course, any combinations of these items can be present. In some illustrative examples, "at least one of" can be, for example, without limitation, two of item A; one of item B; and ten of item C; four of item B and seven of item C; or other suitable combinations.

As used herein, "a number of" when used with reference to items, means one or more items. For example, "a number of different types of networks" is one or more different types of networks. In illustrative example, a "set of" as used with reference items means one or more items.

For example, a set of metrics is one or more of the metrics.

The description of the different illustrative embodiments has been presented for purposes of illustration and description and is not intended to be exhaustive or limited to the embodiments in the form disclosed. The different illustrative examples describe components that perform actions or operations. In an illustrative embodiment, a component can be configured to perform the action or operation described. For example, the component can have a configuration or design for a structure that provides the component an ability to perform the action or operation that is described in the illustrative examples as being performed by the component. Further, to the extent that terms "includes", "including", "has", "contains", and variants thereof are used herein, such terms are intended to be inclusive in a manner similar to the term "comprises" as an open transition word without precluding any additional or other elements.

Many modifications and variations will be apparent to those of ordinary skill in the art. Further, different illustrative embodiments may provide different features as compared to other desirable embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

Further, the disclosure comprises configurations according to the following Clauses:
Clause 1. A computer-implemented method (1000) of manufacturing analysis, the method (1000) comprising:
   identifying (1002) a feature (258) of a product model (254) defined by geometric, physical, and systems elements with semantic labels, names or title descriptions;
   creating (1004) machine readable semantic links (210) that connect the feature (258) to elements (244) in an enterprise knowledge library (240) according to a machine readable ontological knowledge model (202);
   identifying (1006) a producibility risk or opportunity (272) for the product model (254) according to semantic relationships (208) of the elements (244) in the enterprise knowledge library (240) linked to the feature (258);
   alerting (1008) a user of the producibility risk or opportunity; and
   adding (1010) a note (250) to a manufacturing design specification (246) for the product model (254), wherein the note (250) provides a number of solutions for the producibility risk or opportunity, wherein the solutions are identified in the enterprise knowledge library (240) according to the semantic relationships (208).
Clause 2. The method (1000) of Clause 1, further comprising using a digital thread (270) to collect and link the producibility risk or opportunity, and measured criteria relevant to the producibility risk or opportunity, to a final product for quality assurance.
Clause 3. The method (1000) of Clause 1 or 2, wherein identifying (1006) the producibility risk or opportunity (272) is performed via natural language processing.
Clause 4. The method (1000) of any one of the preceding Clause, wherein the feature (258) of the product model (254) comprises at least one of:
   Package folder;
   Collector;
   System Block;
   Behavior;
   Object;
   Object Property;
   Object Method;
   Physical product;
   Part;
   3D Shape specification;
   Annotation set;
   Note;
   points;
   lines;
   planes;
   curves;
   surfaces; or
   solid shapes.
Clause 5. The method (1000) of any one of the preceding Clauses, wherein the feature (258) of the product model (254) comprises an entity within a computer aided design, CAD, environment that defines geometric or functional portion of a part.
Clause 6. The method (1000) of any one of the preceding Clauses, wherein the geometric, physical, and systems elements comprise at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 7. The method (1000) of any one of the preceding Clauses, wherein the enterprise knowledge library (240) comprises at least one of:
   a database of manufacturing processes and process standards relevant to a feature, part, object or assembly of objects;
   a database of design guidance, manuals, recommendations, checklists, processes, and practices;
   a database of manufacturing assets relevant to manufacturing processes for the object;
   a database of previously-identified non-conformances, defects, failure modes effect analysis, or risks relevant to manufacturing processes for the object and means of resolution or improvement of the processes; and
   a database of formally modeled, machine-readable ontologies unique to a company's intellectual property, research, interests and business, and industry standards.
Clause 8. The method (1000) of Clause 1 or 2, wherein identifying (1006) the producibility risk or opportunity (272) for the product model (254) is performed through semantic analysis of the enterprise knowledge library (240) .
Clause 9. The method (1000) of any one of the preceding Clauses, wherein the solutions for the producibility risk or opportunity (272) comprise at least one of:
   a change of design specifications (262) of the product model; or
   a change of configuration (264) of the product model.
Clause 10. The method (1000) of Clause 9, wherein the design specifications (262) comprise at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 11. The method (1000) of Clause 9 or 10, wherein the configuration (264) comprises at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 12. The method (1000) of any one of the preceding Clauses, wherein identifying (1002) a feature (258) of a product model (254) further comprises identifying a variant of the product model (254).
Clause 13. The method (1000) of Clause 12, wherein the variant of the product model (254) comprises a manufactured state (226) of the product model (254).
Clause 14. A system for manufacturing analysis, the system comprising:
   a storage device (1116) configured to store program instructions;
   one or more processors (1104) operably connected to the storage device (1116) and configured to execute the program instructions to cause the system to:
      identify (1002) a feature (258) of a product model (254) defined by geometric, physical, and systems elements with semantic labels, names or title descriptions;
      create (1004) machine readable semantic links (210) that connect the feature (258) to elements (244) in an enterprise knowledge library (240) according to a machine readable ontological knowledge model (202);
      identify (1006) a producibility risk or opportunity (272) for the product model (254) according to semantic relationships (208) of the elements in the enterprise knowledge library (240) linked to the feature (258);
      alert (1008) a user of the producibility risk or opportunity; and
      add (1010) a note (250) to a manufacturing design specification (246) for the product model (254), wherein the note (250) provides a number of solutions for the producibility risk or opportunity, wherein the solutions are identified in the enterprise knowledge library (240) according to the semantic relationships (208).
Clause 15. The system of Clause 14, wherein the processors (1104) are further configured to execute program instructions to cause the system to use a digital thread (270) to collect and link the producibility risk or opportunity, and measured criteria relevant to the producibility risk or opportunity, to a final product for quality assurance.
Clause 16. The system of Clause 14 or 15, wherein identifying (1006) the producibility risk or opportunity (272) is performed via natural language processing.
Clause 17. The system of any one of Clauses 14 to 16, wherein the feature (258) of the product model (254) comprises at least one of:
   Package folder;
   Collector;
   System Block;
   Behavior;
   Object;
   Object Property;
   Object Method;
   Physical product;
   Part;
   3D Shape specification;
   Annotation set;
   Note;
   points;
   lines;
   planes;
   curves;
   surfaces; or
   solid shapes.
Clause 18. The system of any of Clauses 14 to 17, wherein the feature (258) of the product model (254) comprises an entity within a computer aided design, CAD, environment that defines geometric or functional portion of a part.
Clause 19. The system of any one of Clauses 14 to 18, wherein the geometric, physical, and systems elements comprise at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 20. The system of any one of Clauses 14 to 19, wherein the enterprise knowledge library (240) comprises at least one of:
   a database of manufacturing processes and process standards relevant to a feature, part, object or assembly of objects;
   a database of design guidance, manuals, recommendations, checklists, processes, and practices;
   a database of manufacturing assets relevant to manufacturing processes for the object;
   a database of previously-identified non-conformances, defects, failure modes effect analysis, or risks relevant to manufacturing processes for the object and means of resolution or improvement of the processes; and
   a database of formally modeled, machine-readable ontologies unique to a company's intellectual property, research, interests and business, and industry standards.
Clause 21. The system of Clause 14 or 15, wherein identifying (1006) the producibility risk or opportunity (272) for the product model (254) is performed through semantic analysis of the enterprise knowledge library (240) .
Cluase 22. The system of any one of Clauses 14 to 21, wherein the solutions for the producibility risk or opportunity (272) comprise at least one of:
   a change of design specifications (262) of the product model; or
   a change of configuration (264) of the product model.
Clause 23. The system of Clause 22, wherein the design specifications (262) comprise at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 24. The system of Clause 22 or 23, wherein the configuration (264) comprises at least one of:
   material properties;
   ply stack thickness;
   radius of curvature;
   manufacturing features;
   manufacturing quality;
   manufacturing tools;
   machining specifications;
   painting specifications;
   inspection specifications;
   wash and dry processes;
   index tool coordination features;
   tool coordination;
   geometric dimensioning and tolerancing; or
   transportation, handling, and logistic features.
Clause 25. The system of any one of Clauses 14 to 24, wherein identifying (1002) a feature (258) of a product model (254) further comprises identifying a variant of the product model (254).
Clause 26. The system of Clause 25, wherein the variant of the product model (254) comprises a manufactured state (226) of the product model (254).
Clause 27. A computer program product for manufacturing analysis, the computer program product comprising:
   a computer-readable storage medium (1124) having program instructions embodied thereon to perform the operations of:
   identifying (1002) a feature (258) of a product model (254) defined by geometric, physical, and systems elements with semantic labels, names or title descriptions;
   creating (1004) machine readable semantic links (210) that connect the feature (258) to elements (244) in an enterprise knowledge library (240) according to a machine readable ontological knowledge model (202);
   identifying (1006) a producibility risk or opportunity (272) for the product model (254) according to semantic relationships (208) of the elements (244) in the enterprise knowledge library (240) linked to the feature (258);
   alerting (1008) a user of the producibility risk or opportunity (272); and
   adding (1010) a note (250) to a manufacturing design specification (246) for the product model (254), wherein the note (250) provides a number of solutions for the producibility risk or opportunity (272), wherein the solutions are identified in the enterprise knowledge library (240) according to the semantic relationships (208) .

## Claims

1. A computer-implemented method (1000) of manufacturing analysis, the method (1000) comprising:
identifying (1002) a feature (258) of a product model (254) defined by geometric, physical, and systems elements with semantic labels, names or title descriptions;
creating (1004) machine readable semantic links (210) that connect the feature (258) to elements (244) in an enterprise knowledge library (240) according to a machine readable ontological knowledge model (202);
identifying (1006) a producibility risk or opportunity (272) for the product model (254) according to semantic relationships (208) of the elements (244) in the enterprise knowledge library (240) linked to the feature (258);
alerting (1008) a user of the producibility risk or opportunity; and
adding (1010) a note (250) to a manufacturing design specification (246) for the product model (254), wherein the note (250) provides a number of solutions for the producibility risk or opportunity, wherein the solutions are identified in the enterprise knowledge library (240) according to the semantic relationships (208).

2. The method (1000) of claim 1, further comprising using a digital thread (270) to collect and link the producibility risk or opportunity, and measured criteria relevant to the producibility risk or opportunity, to a final product for quality assurance.

3. The method (1000) of claim 1 or 2, wherein identifying (1006) the producibility risk or opportunity (272) is performed via natural language processing.

4. The method (1000) of any one of the preceding claims, wherein the feature (258) of the product model (254) comprises at least one of:
Package folder;
Collector;
System Block;
Behavior;
Object;
Object Property;
Object Method;
Physical product;
Part;
3D Shape specification;
Annotation set;
Note;
points;
lines;
planes;
curves;
surfaces; or
solid shapes.

5. The method (1000) of any one of the preceding claims, wherein the feature (258) of the product model (254) comprises an entity within a computer aided design, CAD, environment that defines geometric or functional portion of a part.

6. The method (1000) of any one of the preceding claims, wherein the geometric, physical, and systems elements comprise at least one of:
material properties;
ply stack thickness;
radius of curvature;
manufacturing features;
manufacturing quality;
manufacturing tools;
machining specifications;
painting specifications;
inspection specifications;
wash and dry processes;
index tool coordination features;
tool coordination;
geometric dimensioning and tolerancing; or
transportation, handling, and logistic features.

7. The method (1000) of any one of the preceding claims, wherein the enterprise knowledge library (240) comprises at least one of:
a database of manufacturing processes and process standards relevant to a feature, part, object or assembly of objects;
a database of design guidance, manuals, recommendations, checklists, processes, and practices;
a database of manufacturing assets relevant to manufacturing processes for the object;
a database of previously-identified non-conformances, defects, failure modes effect analysis, or risks relevant to manufacturing processes for the object and means of resolution or improvement of the processes; and
a database of formally modeled, machine-readable ontologies unique to a company's intellectual property, research, interests and business, and industry standards.

8. The method (1000) of claim 1 or 2, wherein identifying (1006) the producibility risk or opportunity (272) for the product model (254) is performed through semantic analysis of the enterprise knowledge library (240) .

9. The method (1000) of any one of the preceding claims, wherein the solutions for the producibility risk or opportunity (272) comprise at least one of:
a change of design specifications (262) of the product model; or
a change of configuration (264) of the product model.

10. The method (1000) of claim 9, wherein the design specifications (262) comprise at least one of:
material properties;
ply stack thickness;
radius of curvature;
manufacturing features;
manufacturing quality;
manufacturing tools;
machining specifications;
painting specifications;
inspection specifications;
wash and dry processes;
index tool coordination features;
tool coordination;
geometric dimensioning and tolerancing; or
transportation, handling, and logistic features.

11. The method (1000) of claim 9 or 10, wherein the configuration (264) comprises at least one of:
material properties;
ply stack thickness;
radius of curvature;
manufacturing features;
manufacturing quality;
manufacturing tools;
machining specifications;
painting specifications;
inspection specifications;
wash and dry processes;
index tool coordination features;
tool coordination;
geometric dimensioning and tolerancing; or
transportation, handling, and logistic features.

12. The method (1000) of any one of the preceding claims, wherein identifying (1002) a feature (258) of a product model (254) further comprises identifying a variant of the product model (254).

13. The method (1000) of claim 12, wherein the variant of the product model (254) comprises a manufactured state (226) of the product model (254).

14. A system for manufacturing analysis, the system comprising:
a storage device (1116) configured to store program instructions;
one or more processors (1104) operably connected to the storage device (1116) and configured to execute the program instructions to cause the system to:
identify (1002) a feature (258) of a product model (254) defined by geometric, physical, and systems elements with semantic labels, names or title descriptions;
create (1004) machine readable semantic links (210) that connect the feature (258) to elements (244) in an enterprise knowledge library (240) according to a machine readable ontological knowledge model (202);
identify (1006) a producibility risk or opportunity (272) for the product model (254) according to semantic relationships (208) of the elements in the enterprise knowledge library (240) linked to the feature (258);
alert (1008) a user of the producibility risk or opportunity; and
add (1010) a note (250) to a manufacturing design specification (246) for the product model (254), wherein the note (250) provides a number of solutions for the producibility risk or opportunity, wherein the solutions are identified in the enterprise knowledge library (240) according to the semantic relationships (208).

15. A computer program product for manufacturing analysis, the computer program product comprising:
a computer-readable storage medium (1124) having program instructions embodied thereon to perform the operations of:
identifying (1002) a feature (258) of a product model (254) defined by geometric, physical, and systems elements with semantic labels, names or title descriptions;
creating (1004) machine readable semantic links (210) that connect the feature (258) to elements (244) in an enterprise knowledge library (240) according to a machine readable ontological knowledge model (202);
identifying (1006) a producibility risk or opportunity (272) for the product model (254) according to semantic relationships (208) of the elements (244) in the enterprise knowledge library (240) linked to the feature (258);
alerting (1008) a user of the producibility risk or opportunity (272); and
adding (1010) a note (250) to a manufacturing design specification (246) for the product model (254), wherein the note (250) provides a number of solutions for the producibility risk or opportunity (272), wherein the solutions are identified in the enterprise knowledge library (240) according to the semantic relationships (208) .
